(19) Europäisches Patentamt

European Patent Office

Office européen des brevets

(11) **EP 0 350 663 B1**

(12) **EUROPÄISCHE PATENTSCHRIFT**

(45) Veröffentlichungstag und Bekanntmachung des Hinweises auf die Patenterteilung:
**11.09.1996 Patentblatt 1996/37**

(51) Int Cl.6: **H03D 1/22**, H04H 1/00

(21) Anmeldenummer: **89111145.2**

(22) Anmeldetag: **20.06.1989**

(54) **Schaltungsanordnung zur Demodulation eines Hilfsträgers**

Circuit arrangement for the demodulation of a subcarrier

Montage de circuit pour la démodulation d'une sous-porteuse

(84) Benannte Vertragsstaaten:
**AT CH DE ES FR GB IT LI SE**

(30) Priorität: **12.07.1988 DE 3823552**

(43) Veröffentlichungstag der Anmeldung:
**17.01.1990 Patentblatt 1990/03**

(73) Patentinhaber: **Blaupunkt-Werke GmbH
D-31132 Hildesheim (DE)**

(72) Erfinder: **Hegeler, Wilhelm
D-3200 Hildesheim (DE)**

(56) Entgegenhaltungen:
EP-A- 0 062 872          EP-A- 0 156 701
EP-A- 0 200 977          EP-A- 0 256 287

**Beschreibung**

Die Erfindung geht aus von einem Verfahren nach der Gattung des Hauptanspruchs.

Bei der Amplitudendemodulation und Digitalisierung eines schwachen Nutzsignals mit einer bekannten Anordnung, die aus einem Mischer, einem Tiefpaß und einem Analog/Digital-Wandler besteht, tritt am Ausgang ein additiver Fehler auf. Insbesondere bei einem Nutzsignal, wie beispielsweise dem Hilfsträger des Verkehrsfunksystems und des Radiodatensystems (RDS) kann dieser Fehler auftreten.

Aufgabe der Erfindung ist es, ein Verfahren zur Demodulation eines Hilfsträgers anzugeben, bei welcher eine digitale Weiterverarbeitung des Nutzsignals möglich ist, ohne daß ein additiver Fehler auftritt. Da ferner im Zusammenhang mit dem Hilfsträger stärkere Störsignale wie beispielsweise Audiosignale und der Stereopilot-Ton auftreten, ist außerdem eine Störsicherheit der Schaltung, insbesondere eine Unterdrückung von Spiegelfrequenzen erforderlich.

Das erfindungsgemäße Verfahren mit den kennzeichnenden Merkmalen des Hauptanspruchs hat den Vorteil, daß eine digitale Weiterverarbeitung des Nutzsignals möglich ist, praktisch kein additiver Fehler auftritt und daß eine genügend große Störsicherheit vorliegt. Außerdem läßt sich das erfindungsgemäße Verfahren mit geringem Aufwand realisieren und ist für eine integrierte Schaltung geeignet.

Als Mischsignale eignen sich unter anderem Rechtecksignale und sogenannte Tristate-Signale. Letztere haben den Vorteil, daß sie bei geeigneter Wahl der Tastverhältnisse keine dritte Oberwelle enthalten, weshalb im Nutzband keine Mischprodukte der Frequenzen um $3 \omega_o \pm 4,75$ kHz entstehen. Die Tristate-Signale können mit Hilfe einer Schaltlogik und einem 1:12-Frequenzteiler aus der Frequenz $12 * \omega_o = 741$ kHz erzeugt werden.

Da das erfindungsgemäße Verfahren an die Geschwindigkeit der Analog/Digital-Wandler nur geringe Anforderung stellt, lassen sich einfache, gut integrierbare Analog/Digital-Wandler (beispielsweise Delta-Wandler oder Sigma-Delta-Wandler) verwenden, die im Niederfrequenzbereich eine große Dynamik der zu wandelnden Signale gestatten.

An sich ist aus der EP-A-0 156 701 eine analoge Frequenzverschiebung in das Basisband, eine anschließende Digitalisierung, und die Bildung zweier in Quadratur stehender Signale, mittels Register, Komplementärbildner und Multiplexer bekannt.

Durch die in den Unteransprüchen aufgeführten Maßnahmen sind vorteilhafte Weiterbildungen und Verbesserungen der im Hauptanspruch angegebenen Erfindung möglich.

Bei einer bevorzugten Ausführungsform des erfindungsgemäßen Verfahrens werden zwei Mischsignale mit einem Phasenunterschied von 90° erzeugt. Durch eine viermalige Abtastung pro Periode der Mischprodukte ist eine Ableitung beider Quadraturkomponenten in einfacher Weise möglich. Die Erfindung umfaßt jedoch auch die Erzeugung von mehr als zwei Mischsignalen mit entsprechenden Phasenunterschieden und eine häufigere Abtastung der Mischprodukte. Dabei stehen bei einer geraden Anzahl von Mischsignalen ohne weiteres Abtastwerte für beide Quadraturkomponenten zur Verfügung. Es lassen sich jedoch auch bei einer ungeraden Anzahl von Mischsignalen Quadraturkomponenten ableiten, wobei die eine direkt und die andere durch Interpolation zwischen zwei Abtastwerten gewonnen werden kann.

Ausführungsbeispiele der Erfindung sind in der Zeichnung anhand mehrerer Figuren dargestellt und in der nachfolgenden Beschreibung näher erläutert. Es zeigt:

Fig. 1 ein Blockschaltbild eines Ausführungsbeispiels,

Fig. 2 eine tabellarische Darstellung der Funktion der Anordnung nach Fig. 1 und

Fig. 3 eine tabellarische Darstellung zur Erläuterung einer erfindungsgemäßen Schaltungsanordnung mit drei Mischsignalen.

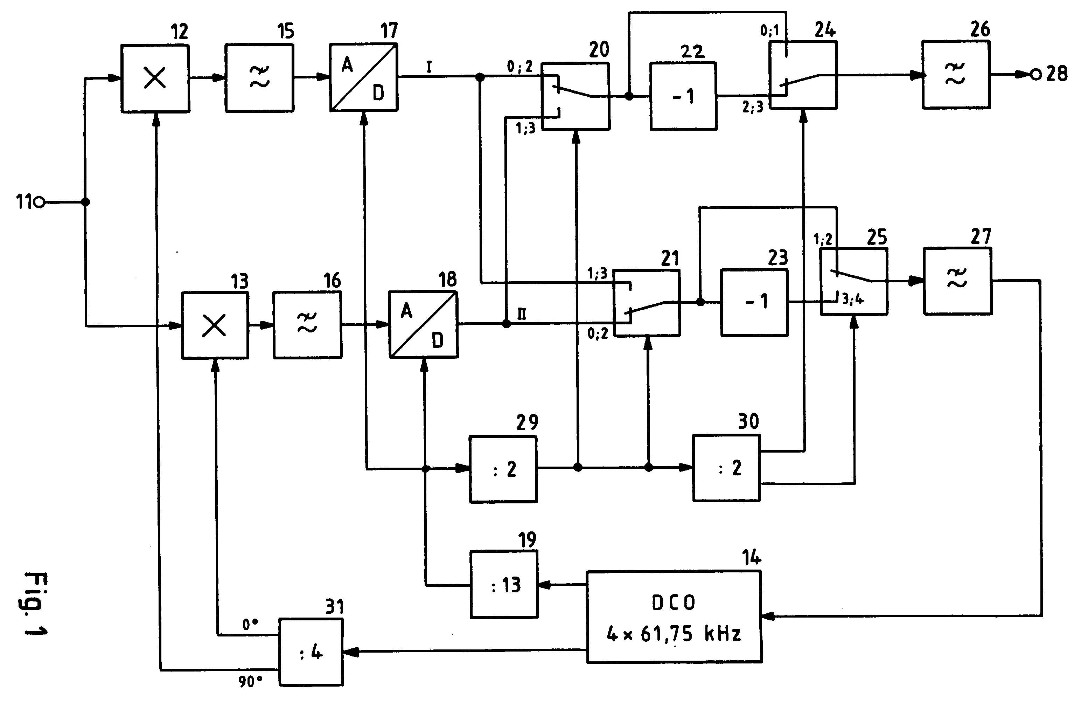

Der Schaltungsanordnung nach Fig. 1 wird bei 11 das zu demodulierende Signal zugeführt. Es folgt der Beziehung $A(t) * \sin(\omega t + \varphi)$. Dabei ist $A(t)$ das Modulationssignal, während $\omega$ und $\varphi$ wie üblich für die Kreisfrequenz und die Phasenlage des Trägers stehen.

Der RDS- und Verkehrsfunk-Hilfsträger weist eine Frequenz von 57 KHz auf. Den Mischern 12, 13 wird je ein Mischsignal zugeführt, dessen Frequenz 61,75 KHz beträgt. Es wird in einem digital steuerbaren Oszillator 14 und einem anschließenden Frequenzteiler 31 in zwei um 90° voneinander verschiedenen Phasenlagen durch Frequenzteilung eines Signals mit vierfacher Frequenz der Mischsignale erzeugt.

Durch anschließende Tiefpaßfilter 15, 16 werden Spektralanteile oberhalb des Nutzfrequenzbereichs unterdrückt. Die Ausgangssignale der Tiefpaßfilter 15, 16 ergeben sich dann zu $A(t) * \cos((\omega_o - \omega_{57})t + \varphi)$ bzw. $A(t) * \sin((\omega_o - \omega_{57})t + \varphi)$. Durch die Mischung wird das Modulationssignal $A(t)$ noch nicht in das Basisband umgesetzt, sondern es entstehen lediglich modulierte Träger mit der Frequenz von 4,75 KHz.

Beide Signale, die im folgenden Zwischenfrequenzsignale genannt werden, werden je einem Analog/Digital-Wandler 17, 18 zugeführt, wobei eine Taktfrequenz von 19 KHz vorgesehen ist, die durch Teilung der Frequenz des Oszillators 14 durch 13 mit Hilfe eines Frequenzteilers 19 erzeugt wird und die Zwischenfrequenzsignale jeweils viermal je Periode abtastet.

An die Ausgänge der Analog/Digital-Wandler 17, 18 schließen sich zwei Kanäle I und II an, die jeweils von einem steuerbaren Umschalter 20, 21, einem Signalinvertierer 22, 23, einem weiteren steuerbaren Umschalter 24, 25 und einem Tiefpaßfilter 26, 27 gebildet werden. Das Ausgangssignal des Tiefpaßfilters 26 kann einem Ausgang 28 entnommen werden, während das Ausgangssignal des Tiefpaßfilters 27 bei dem dargestellten Ausführungsbeispiel zur Steuerung des digital steuerbaren Oszillators 14 verwendet wird.

Über zwei weitere Frequenzteiler 29, 30 werden die Schalter 20, 21, 24, 25 derart gesteuert, daß im Kanal I jeweils eine Abtastung bei 0° und 180° bezogen auf eine Periode des Zwischenfrequenzsignals erfolgt, während im Kanal II bei 90° und 270° abgetastet wird. Jeder zweite Abtastwert wird mit Hilfe der Schaltungen 22, 23 invertiert, so daß eine Demodulation in das Basisband erfolgt. Nach einem Ausfiltern von Trägerresten mit Hilfe der Tiefpaßfilter 26, 27 stehen die demodulierten Signale zur Verfügung. Dabei entspricht das Signal am Ausgang 28 der Cosinus-Komponente des Modulationssignals, während am Ausgang des Tiefpaßfilters 27 eine Sinus-Komponente zur Verfügung steht, die bei dem dargestellten Ausführungsbeispiel zur Regelung benutzt wird.

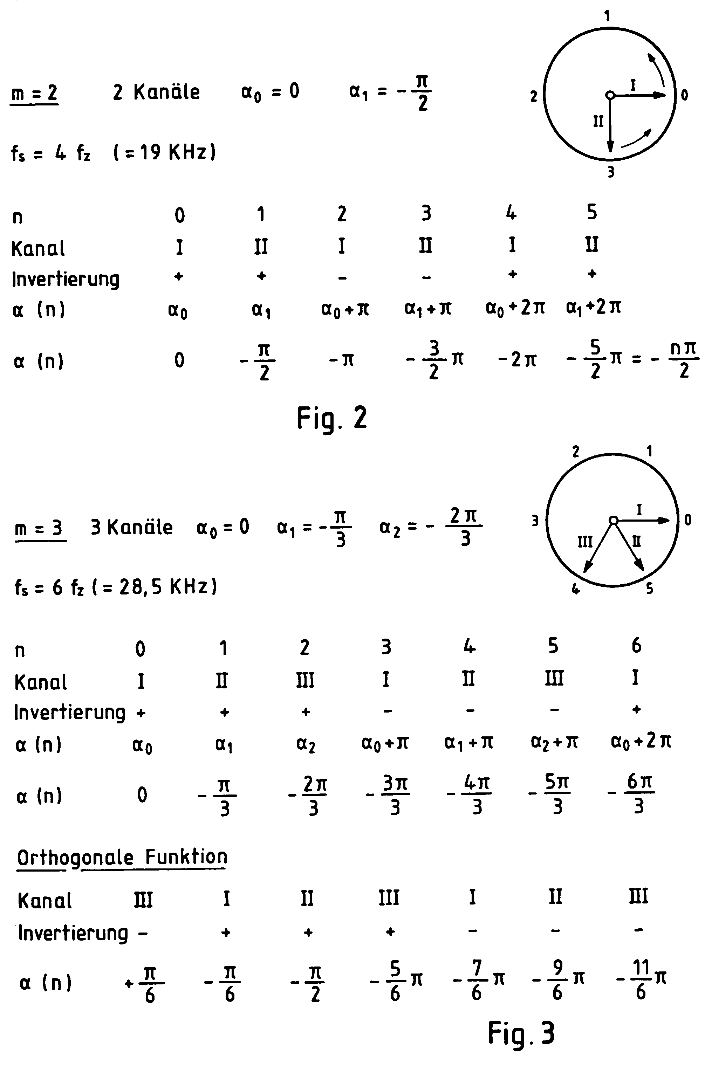

Die Steuerung der Umschalter mit Hilfe der Frequenzteiler 29, 30 wird im folgenden anhand von Fig. 2 näher erläutert. Dabei bedeutet n die Ordnungszahl der jeweiligen Abtastung, + oder - ob eine Signalinvertierung stattfindet und φ (n) der jeweilige Winkel der Abtastung in allgemeiner Form und mit 0 als Anfangswert. In Fig. 1 sind die Stellungen der Umschalter mit den Werten für n gekennzeichnet, bei denen die jeweilige Stellung eingenommen wird. So befindet sich beispielsweise der Umschalter 20 bei n = 0 und bei n = 2 im oberen und bei n = 1 und bei n = 3 in der unteren Stellung.

Der Tabelle gemäß Fig. 2 kann entnommen werden, daß die Abtastwerte abwechselnd aus dem Kanal I und dem Kanal II entnommen werden. Jeweils zwei aufeinanderfolgende Abtastwerte werden mit gleichem Vorzeichen weitergeleitet, so daß jede zweite Halbwelle des Zwischenfrequenzsignals invertiert wird. Durch diese Invertierung wird ein gegebenenfalls vorhandener Offsetfehler bei der Abtastung jeweils eines der Kanäle I oder II abwechselnd invertiert und nicht invertiert. Der Offsetfehler wird somit in eine Frequenz von 4,75 kHz umgesetzt, die von dem anschließenden Tiefpaßfilter 26 bzw. 27 unterdrückt wird.

Die in Fig. 2 dargestellte Tabelle gilt für eines der Ausgangssignale, während das andere Ausgangssignal durch Vertauschung der Kanäle I und II und durch eine Invertierung bei n = 0, 3, 4, 7, 8 usw. erfolgt. Außer der Tabelle zeigt Fig. 2 noch als graphische Darstellung die Abtastzeitpunkte 0, 1, 2, 3 und die Zwischenfrequenzsignale, wobei das Signal des Kanals I demjenigen des Kanals II um 90° voreilt.

Bei dem der Tabelle nach Fig. 2 zugrundeliegenden Ausführungsbeispiel beträgt die Abtastfrequenz fs = 19 kHz. In diesem Zusammenhang bedeutet Abtastfrequenz diejenige Frequenz, mit der die Ausgangssignale der Analog/Digital-Wandler bzw. nachgeschalteter Filter weiterverarbeitet werden.

Während bei dem im Zusammenhang mit den Figuren 1 und 2 erläuterten Ausführungsbeispiel zwei Kanäle vorgesehen sind, erläutert die Tabelle gemäß Fig. 3 ein Ausführungsbeispiel mit drei Kanälen. Dabei betragen die Phasenunterschiede jeweils π/3. Die Abtastfrequenz fs beträgt das Sechsfache der Zwischenfrequenz, was bei einer Zwischenfrequenz von 4,75 kHz einer Abtastfrequenz von 28,5 kHz entspricht. Die Zwischenfrequenzsignale sind in dem Kreisdiagramm gemäß Fig. 3 dargestellt, das ferner die sechs Abtastzeitpunkte 0 bis 5 zeigt. In der Tabelle gemäß Fig. 3 sind für die Abtastzeitpunkte der jeweils abzutastende Kanal, das Vorzeichen und der Winkel der Abtastung für beide orthogonalen Komponenten aufgeführt.

**Patentansprüche**

1. Verfahren zur Demodulation eines analogen Trägersignales, insbesondere bei einem Radiodatensystem, wobei zur Bildung eines Ausgangssignals ein Trägersignal mit einem Mischsignal gemischt wird, anschließend gefiltert und digitalisiert wird, dadurch gekennzeichnet, daß das Trägersignal mit mindestens einem zweiten Mischsignal gemischt wird, daß das erste und das zweite Mischsignal gegeneinander phasenverschoben sind und eine vorgegebene Frequenz aufweisen, die außerhalb des Nutzbandes des Trägersignales liegt, daß durch die Mischung des Trägersignals mit den zwei Mischsignalen zwei Mischprodukte erhalten werden, daß daraufhin Frequenzen über dem Nutzfrequenzbereich der Mischprodukte aus den Mischprodukten herausgefiltert werden und die gefilterten Mischprodukte digital gewandelt werden, daß anschließend die digitalen Mischprodukte jeweils zweimal pro Periode zu vorgegebenen Zeitpunkten abgetastet werden, daß die Abtastwerte je eines Mischproduktes abwechselnd invertiert werden, und daß als Ausgangssignal abwechselnd ein Abtastwert des einen Mischproduktes und ein Abtastwert des anderen Mischproduktes ausgegeben wird.

2. Verfahren nach Anspruch 1, dadurch gekennzeichnet, daß die Frequenz der Mischsignale um 4,75 kHz über dem Hilfsträger liegen.

3. Verfahren nach Anspruch 1, dadurch gekennzeichnet, daß der Phasenunterschied zwischen den einzelnen Mischsignalen jeweils $\frac{\pi}{m}$ beträgt, wobei m die Anzahl der Mischsignale ist.

4. Verfahren nach Anspruch 1, dadurch gekennzeichnet, daß zwei Mischsignale mit einem Phasenunterschied von $\frac{\pi}{m}$ erzeugt werden und daß die Mischprodukte tiefpaßgefiltert und anschließend 4mal pro Periode abgetastet werden und daß die Abtastwerte beider Mischprodukte zyklisch abwechselnd einem ersten Ausgang, der ein Ausgangssignal entsprechend einer ersten Komponente des Modulationssignals liefert und einem zweiten Ausgang zugeführt werden, der ein Ausgangssignal entsprechend einer zweiten Komponente des Modulationssignals liefert.

5.   Verfahren nach Anspruch 4,
daß eines der Ausgangssignale die Frequenz des Mischsignalgenerators steuert.

6.   Verfahren nach Anspruch 4,
dadurch gekennzeichnet,
daß das Ausgangssignal eines Hilfsträgerfilters jeweils einem ersten Eingang zweier Mischer (12, 13) zuführbar ist, deren zweiten Eingänge mit Ausgängen eines Mischsignalgenerators (14) verbunden sind, wobei die Ausgänge des Mischsignalgenerators (14) zwei um 90° phasenverschobene Mischsignale führen, daß die Ausgänge der Mischer (12, 13) bei je ein Tiefpaßfilter (15, 16) mit je einem Analogdigitalwandler (17, 18) verbunden sind und daß die Ausgänge der Digitalanalogwandler an Eingängen von zwei Umschalteinrichtungen (20, 21) angeschlossen sind, deren Ausgänge jeweils zum einen mit einem ersten Eingang eines zugeordneten Umschalters (24, 25) direkt und mit einem zweiten Eingang über eine Inverterstufe (22, 23) verbunden ist und daß an den Ausgängen der zugeordneten Umschalter die den Hilfsträger modulierenden Signale abnehmbar sind.

## Claims

1.   Method for demodulation of an analogue carrier signal, in particular in the case of a radio data system, a carrier signal being mixed with a mixing signal in order to form an output signal, and then being filtered and digitized, characterized in that the carrier signal is mixed with at least one second mixing signal, in that the first mixing signal and the second mixing signal are phase-shifted with respect to one another and are at a predetermined frequency which is outside the band used by the carrier signal, in that two mixed products are obtained by mixing the carrier signal with the two mixing signals, in that frequencies above the wanted frequency range of the mixed products are filtered out of the mixed products and the filtered mixed products are digitally converted, in that the digital mixed products are then in each case sampled twice per period at predetermined points in time, in that the samples of in each case one mixed product are alternately inverted, and in that a sample from one mixed product and a sample from the other mixed product are output alternately as the output signal.

2.   Method according to Claim 1, characterized in that the frequency of the mixing signals is 4.75 kHz above the auxiliary carrier.

3.   Method according to Claim 1, characterized in that the phase difference between the individual mixing signals is in each case $\pi/m$, m being the number of mixing signals.

4.   Method according to Claim 1, characterized in that two mixing signals having a phase difference of $\pi/2$ are produced and in that the mixed products are low-pass filtered and are subsequently sampled four times per period, and in that the samples of both mixed products are supplied cyclically and alternately to a first output, which delivers an output signal corresponding to a first component of the modulation signal, and to a second output, which delivers an output signal corresponding to a second component of the modulation signal.

5.   Method according to Claim 4, characterized in that one of the output signals controls the frequency of the mixing signal generator.

6.   Method according to Claim 4, characterized in that the output signal of an auxiliary carrier filter can in each case be supplied to a first input of two mixers (12, 13), whose second inputs are connected to outputs of a mixing signal generator (14), the outputs of the mixing signal generator (14) carrying two mixing signals which are phase-shifted through 90°, in that the outputs of the mixers (12, 13) for in each case one low-pass filter (15, 16) are connected to in each case one analogue/digital converter (17, 18), and in that the outputs of the digital/analogue converter are connected to inputs of two changeover devices (20, 21) whose outputs are in each case connected on the one hand directly to a first input of an associated changeover switch (24, 25) and to a second input via an invertor stage (22, 23), and in that the signals which modulate the auxiliary carrier can be picked off at the outputs of the associated changeover switches.

## Revendications

1.   Procédé de démodulation d'une porteuse analogique notamment dans un système de radio numérique, selon lequel, pour former un signal de sortie on mélange un signal de porteuse à un signal de mélange puis on filtre et on numérise,
caractérisé en ce que
le signal de porteuse est mélangé à au moins un second signal de mélange, le premier et le second signal de mélange étant déphasés l'un par rapport à l'autre et ayant une fréquence prédéterminée, extérieure à la bande utile du signal de porteuse, et par mélange du signal de porteuse et des deux signaux de mélange, on obtient deux produits de mélange, dans les produits de mélange on élimine les fréquences supérieures à la plage de fréquences utiles des produits de mélange et on numérise les produits de mélange filtrés, on détecte chacun des produits de mélange numérisés, deux fois par période, à des instants prédéterminés, on inverse alternativement les valeurs de détection de chaque produit de mélange et on émet comme signal de sortie, alternativement une valeur de détection de l'un des produits de mélange et une valeur de détection de l'autre des produits de mélange.

2. Procédé selon la revendication 1, caractérisé en ce que la fréquence des signaux de mélange dépasse de 4,75 kHz la sous-porteuse.

3. Procédé selon la revendication 1, caractérisé en ce que la différence de phase entre les diverses signaux de mélange est égale à $\pi/m$, m étant le nombre des signaux de mélange.

4. Procédé selon la revendication 1, caractérisé en ce que l'on génère deux signaux de mélange avec une différence de phase égale à $\pi/2$, on filtre les produits de mélange par un filtre passe-bas, puis on détecte quatre fois par période et on applique les valeurs de détection des deux produits de mélange, alternativement, de manière cyclique à une première sortie donnant un signal de sortie correspondant à une première composante du signal de modulation et à une seconde sortie qui fournit un signal de sortie correspondant à une seconde composante du signal de modulation.

5. Procédé selon la revendication 4, caractérisé en ce que l'un des signaux de sortie commande la fréquence du générateur de signal de mélange.

6. Procédé selon la revendication 4, caractérisé en ce que le signal de sortie d'un filtre de sous-porteuse est appliqué chaque fois à une première entrée de deux mélangeurs (12, 13) dont les secondes entrées sont reliées aux sorties d'un générateur de signal de mélange (14), les sorties de ce générateur de signal de mélange (14) donnant deux signaux de mélange déphasés de 90°, les sorties du mélangeur (12, 13) de chaque filtre passe-bas (15, 16) étant reliées chacune à un convertisseur analogique/numérique (17, 18) et les sorties des convertisseurs sont reliées aux entrées de deux commutateurs (20, 21) dont les sorties sont reliées, d'une part, directement à une première entrée d'un commutateur correspondant (24, 25) et, d'autre part, à une seconde entrée par un étage inverseur (22, 23), les sorties des commutateurs correspondants, fournissant les signaux de modulation de la sous-porteuse.

Fig. 1

$\underline{m = 2}$  2 Kanäle  $\alpha_0 = 0$  $\alpha_1 = -\dfrac{\pi}{2}$

$f_s = 4\, f_z$  $(= 19\ \text{KHz})$

| n | 0 | 1 | 2 | 3 | 4 | 5 |
|---|---|---|---|---|---|---|
| Kanal | I | II | I | II | I | II |
| Invertierung | + | + | − | − | + | + |
| $\alpha(n)$ | $\alpha_0$ | $\alpha_1$ | $\alpha_0+\pi$ | $\alpha_1+\pi$ | $\alpha_0+2\pi$ | $\alpha_1+2\pi$ |
| $\alpha(n)$ | 0 | $-\dfrac{\pi}{2}$ | $-\pi$ | $-\dfrac{3}{2}\pi$ | $-2\pi$ | $-\dfrac{5}{2}\pi = -\dfrac{n\pi}{2}$ |

## Fig. 2

$\underline{m = 3}$  3 Kanäle  $\alpha_0 = 0$  $\alpha_1 = -\dfrac{\pi}{3}$  $\alpha_2 = -\dfrac{2\pi}{3}$

$f_s = 6\, f_z$  $(= 28{,}5\ \text{KHz})$

| n | 0 | 1 | 2 | 3 | 4 | 5 | 6 |
|---|---|---|---|---|---|---|---|
| Kanal | I | II | III | I | II | III | I |
| Invertierung | + | + | + | − | − | − | + |
| $\alpha(n)$ | $\alpha_0$ | $\alpha_1$ | $\alpha_2$ | $\alpha_0+\pi$ | $\alpha_1+\pi$ | $\alpha_2+\pi$ | $\alpha_0+2\pi$ |
| $\alpha(n)$ | 0 | $-\dfrac{\pi}{3}$ | $-\dfrac{2\pi}{3}$ | $-\dfrac{3\pi}{3}$ | $-\dfrac{4\pi}{3}$ | $-\dfrac{5\pi}{3}$ | $-\dfrac{6\pi}{3}$ |

### Orthogonale Funktion

| Kanal | III | I | II | III | I | II | III |
|---|---|---|---|---|---|---|---|
| Invertierung | − | + | + | + | − | − | − |
| $\alpha(n)$ | $+\dfrac{\pi}{6}$ | $-\dfrac{\pi}{6}$ | $-\dfrac{\pi}{2}$ | $-\dfrac{5}{6}\pi$ | $-\dfrac{7}{6}\pi$ | $-\dfrac{9}{6}\pi$ | $-\dfrac{11}{6}\pi$ |

## Fig. 3